# EUROPÄISCHE PATENTSCHRIFT

(11) **EP 0 497 358 B1**
(45) Veröffentlichungstag und Bekanntmachung des Hinweises auf die Patenterteilung: **24.04.1996**
(21) Anmeldenummer: 92101575.6
(22) Anmeldetag: 30.01.1992
(51) Int. Cl.: G02B 6/34, H04J 14/02, G02B 6/12

(54) **Integrierte optische Anordnung zum Demultiplexen mehrerer verschiedener Wellenlängenkanäle und Verfahren zu ihrer Herstellung**
Integrated optical device for demultiplexing various channels of different wavelengths and method of manufacturing therefor
Dispositif optique intégré pour démultiplexage de plusieurs canaux de longueurs d'onde différents et méthode de sa fabrication

(30) Priorität: 21.02.1991 DE 4105465; 01.02.1991 DE 4103095
(43) Veröffentlichungstag der Anmeldung: 05.08.1992
(73) Patentinhaber: SIEMENS AKTIENGESELLSCHAFT, D-80333 München (DE)
(72) Erfinder: Cornelius, Cremer, Dr., W-8011 Poing (DE); Emeis, Norbert, Dr., W-8000 München 90 (DE); Mahlein, Hans, Dr., W-8025 Unterhaching (DE)

(56) Entgegenhaltungen:
- EP-A- 0 275 795
- EP-A- 0 356 190
- EP-A- 0 383 138
- ITG-FACHBERICHTE, KONFERENZ üBER HETEROSTRUKTUR-BAUELEMENTE Bd. 112, 27. April 1990, SCHWäBISCH GMüND, DE Seiten 125-130; CREMER: ' Integriert optischer Spektrograph für WDM Komponenten'
- APPLIED PHYSICS LETTERS. Bd. 59, Nr. 6, 5. August 1991, NEW YORK US Seiten 627 - 629; CREMER ET AL.: 'Grating spectrograph in InGaAsP/InP for dense wavelength division multiplexing'

## Beschreibung

Mit dem optischen Wellenlängenmultiplexverfahren läßt sich die Übertragungskapazität von Glasfasern wesentlich erhöhen und es kann, da es sich um eine optische Vielkanaltechnik handelt, in einfacher Weise auf die einzelnen optischen Wellenlängenkanäle zurückgegriffen werden. Voraussetzung für eine weite Verbreitung dieser Technik sind allerdings zuverlässige und vor allen Dingen kostengünstige Sende- und Empfangsbausteine.

Der bisherige Stand der Technik für einen Kanalabstand von etwa 5 nm umfaßt integriert-optische Anordnungen zum Demultiplexen mehrerer verschiedener optischer Wellenlängenkanäle mit einem die verschiedenen Wellenlängenkanäle spektral zerlegenden optischen Beugungsgitter, die in SiO₂ ausgebildet sind (siehe beispielsweise C. Cremer, A. Reichelt: Verfahren zur Herstellung eines an einem Schichtwellenleiter ausgebildeten Beugungsgitters, deutsche Patentanmeldung P 39 13 242.0 (GR 89 P 1298 DE; C.H. Henry, R.F. Kazarinov, Y. Shani, R.C. Kistler, V. Pol, K.J. Orlowsky: Four-channel wavelength division multiplexers, and bandpass filters based on elliptical Bragg reflectors, J. LT. Vol. 8, No. 5 (1990) S. 748-755; S. Valette: State of the art of integrated optics technology at LETI for achieving passive optical components, Journ. of modern optics, Vol. 35, No. 6 (1988) S. 993-1005). Auch ist eine solche Anordnung in InGaAsP/InP bekannt, die eine hohe Ordnung aufweist (siehe M. Gibbon, G.H.B. Thompson, S.J. Clements, D.J. Moule, C.B. Rogers, C.G. Cureton: Optical performance of integrated 1,5 µm grating wavelength-demultiplexer on InP-based waveguide, Electron. Lett. Vol. 25 (1989)S. 1441-1442).

Ein weiteres Beispiel ist aus den ITG - Fachberichten, Konferenz über Heterostruktur-Bauelemente, Bd. 112, 27. April 1990, Seiten 125-130, bekannt.

Der in Anspruch 1 angegebenen Erfindung liegt die Idee zugrunde, eine integriert optische Anordnung zum Demultiplexen mehrerer verschiedener Wellenlängenkanäle die einen auf einem Substrat integrierten und durch einen Rand begrenzten optischen Schichtwellenleiter mit einem auf dem Rand ausgebildeten optischen Beugungsgitter aufweist, durch zusätzliche Integration weiterer optischer Komponenten auf dem Substrat in ihren funktionellen Eigenschaften zu verbessern, wobei diese weiteren optischen Komponenten einzeln oder in Kombination miteinander auf dem Substrat integrierbar sein sollen, ohne daß die Kompaktheit der Anordnung und ihre technologische Herstellung beeinträchtigt wird.

Der im Anspruch 1 angegebenen Erfindung liegt das Problem zugrunde, eine leicht herstellbare und kompakte integriert-optische Anordnung zum Demultiplexen mehrerer verschiedener optischer Wellenlängenkanäle mit einem optischen Beugungsgitter anzugeben, die nicht nur die zugeführten optischen Wellenlängenkanäle spektral zerlegen, sondern das Licht der spektral zerlegten Kanäle zugleich in optischen Detektoren nachweisen kann.

Die mit der Erfindung erzielten Vorteile bestehen insbesondere darin, daß zuverlässige und vor allem kostengünstige Empfangsbausteine möglich sind, bei denen optische Demultiplexer zusammen mit optischen Detektoren auf einem gemeinsamen Substrat integriert sind, wobei alle Wellenlängenkanäle parallel empfangen werden können.

Die im Anspruch 2 angegebene vorteilhafte Ausgestaltung der Anordnung nach Anspruch 1 hat den Vorteil, daß abbildende Elemente wie Linsen oder Spiegel, die eine Zusatzdämpfung bewirken und Fläche auf dem Substrat beanspruchen, vermieden sind. Es gibt zahlreiche Anordnungen für fokussierende Gitter (siehe M.C. Hutley. Diffraction Gratings, Techniques of physics, Ed. N.H. March, Academic Press 1982). Die höchste Auflösung (beugungsbegrenzt) bietet ein stigmatisch fokussierendes Gitter.

Der im Anspruch 1 angegebenen Erfindung, liegt auch das Problem zugrunde, eine möglichst definierte Ankopplung der Anordnung an eine zuführende Streckenfaser zu erreichen, wobei das Licht der zugeführten und eingekoppelten Wellenlängenkanäle mit einem möglichst großen Divergenzwinkel in den Schichtwellenleiter austritt, um einen möglichst großen Bereich des Beugungsgitters zu beleuchten und dadurch eine hohe Auflösung zu erzielen. Die Verbindung mehrerer nebeneinander geführter Einkoppelwellenleiter bietet den Vorteil, daß beim Lichteinkoppeln in benachbarte Einkoppelwellenleiter eine Verschiebung des Spektrums an den optischen Detektoren erreicht werden und so durch Auswahl eines geeigneten Auskoppelwellenleiters eine gewünschte Zentralwellenlänge auf einen optischen Detektor gelegt werden kann.

Der im Anspruch 1 angegebenen Erfindung, liegt ebenfalls das Problem zugrunde, die Einfügedämpfung und Nachweisempfindlichkeit der integriert-optischen Anordnung zu verbessern und/oder Verluste des Beugungsgitters dieser Anordnung auszugleichen.

Vorteile der erfindungsgemäßen Anordnung nach Anspruch 1 sind darin zu sehen, daß keine zusätzlichen Justagen für Verstärker nötig und damit Kosten reduziert sind und daß sich keine zusätzlichen Koppelverluste zwischen der Anordnung und einer Faser ergeben, wodurch die gesamte interne Verstärkung eines optischen Halbleiterverstärkers von etwa 25 dB zur Verfügung steht, und daß der optische Verstärker auf einer Seite durch einen lichtabsorbierenden optischen Detektor, beispielsweise eine Photodiode, abgeschlossen werden kann, wodurch Rückreflexe von weniger als 0,1 % erreichbar sind.

Eine vorteilhafte Ausgestaltung der Anordnung nach Anspruch 1 ist im Anspruch 3 angegeben. Die Ausführung eines Eingangswellenleiters als optischer Verstärker bietet den Vorteil, daß das Verstärkerrauschen vom nachfolgenden Beugungsgitter auf die optischen Detektoren verteilt und damit pro Detektor verringert wird. Die Ausführung eines Ausgangswellenleiters als optischer Verstärker, bei der dieser Verstärker also zwischen dem Beugungsgitter und dem optischen Detektor angeordnet ist, bietet die Vorteile, daß kein zusätzliches Nebensprechen zwischen den Wellenlängenkanälen auftritt, daß für jeden Kanal eine sehr hohe Verstärkung möglich ist und daß die Verstärker der jeweiligen Kanalwellenlänge angepaßt werden können.

Der optische Verstärker der erfindungsgemäßen integriert-optischen Anordnung nach Anspruch 1 oder 3 kann vorteilhafterweise so hergestellt werden, daß der Verstärker, im Fall nach Anspruch 3 der Ein- und Auskoppelwellenleiter, durch selektive Epitaxie eines eigenen Schichtpakets aufgewachsen und anschließend strukturiert wird. Die technologischen Verfahren der Wellenleiter-Verstärker-Integration entsprechen denen der Wellenleiter-Laser-Integration und können von dort übernommen werden. Eine andere vorteilhafte Herstellungsmöglichkeit für den optischen Verstärker besteht darin, daß der optische Detektor, beispielsweise eine Photodiode, aus demselben Schichtpaket wie der Verstärker besteht. Bei dieser Möglichkeit ist keine zusätzliche Epitaxie für den Verstärker notwendig. Die Funktionsweise eines optischen Verstärkers, der als Detektor verwendet wird, ist beispielsweise in M. Gustavsson, A. Karlsson, L. Thylén: Traveling wave semi-conductor laser amplifier detectors, IEEE LT 8 (1990), S. 610-616 beschrieben. Daraus geht hervor, daß bis zu Datenraten von 200 Mb/s diese Detektoren pin-Photodioden ebenbürtig sind.

Die im Anspruch 4 angegebene Ausgestaltung der Erfindung hat den Vorteil, daß Platz für die optischen Detektoren, insbesondere für deren Kontakte gewonnen wird, und daß Nebensprechen vermieden wird, das bei Verwendung elektrischer Leitungen zum Auseinanderführen bei hohen Bitraten als hohes kapazitives Nebensprechen auftritt.

Die im Anspruch 5 angegebene Ausgestaltung der Erfindung bietet herstellungstechnische Vorteile.

Die in den Ansprüchen 4 und 5 angegebenen Ausgestaltungen beziehen sich auf die in den Ansprüchen 1 und 2 angegebene Erfindung, sind aber auch in Kombination mit allen übrigen Erfindungen und deren Ausgestaltungen realisierbar.

Der im Anspruch 6 angegebenen Ausgestaltung liegt das Problem zugrunde, eine integriert-optische Anordnung zum Demultiplexen mehrerer verschiedener optischer Wellenlängenkanäle für bidirektionalen Betrieb zu schaffen.

In einem bidirektionalen optischen Vielkanalsystem mit Wellenlängenmultiplex-Übertragung werden viele Wellenlängenkanäle von einer Zentrale zu einem Teilnehmer und ein oder mehrere Wellenlängenkanäle vom Teilnehmer zur Zentrale übertragen. Es ist eine Reihe mikrooptischer Anordnungen mit Interferenzfiltern und Beugungsgittern bekannt (siehe H.F. Mahlein: Fibre-optic communication in the wavelength-division multiplex mode, Fibre and Integrated Optics, Vol. 4, S. 339-372 (1983), die für diesen Zweck einsetzbar sind. Diese mikroskopischen Aufbauten können nicht so kostengünstig hergestellt werden, wie es für einen Teilnehmeranschluß unabdingbar ist.

Durch die im Anspruch 6 angegebene Ausgestaltung ist ein kostengünstiges Bauelement geschaffen, das kostengünstig herstellbar ist und für den Teilnehmeranschluß in einem bidirektionalen optischen Vielkanalsystem mit Wellenlängenmultiplex-Übertragung vieler Wellenlängenkanäle von der Zentrale zum Teilnehmer und eines einzelnen oder mehrerer Wellenlängenkanäle vom Teilnehmer zur Zentrale einsetzbar ist.

Vorteilhafte Ausgestaltungen der in Anspruch 6 angegebenen Ausgestaltung sind in den Ansprüchen 7 und 8 angegeben.

Vorteilhafte Ausgestaltungen von Ausgangswellenleitern, Eingangswellenleitern und optischen Detektoren, die insbesondere herstellungstechnisch vorteilhaft sind, gehen aus den Ansprüchen 9 bis 11 hervor.

Die in den Ansprüchen 12 bis 15 angegebenen vorteilhaften Verfahren zur Herstellung einer erfindungsgemäßen integriert-optischen Anordnung sind auf die Erfindung nach Anspruch 1 bezogen, wobei mit diesen Verfahren insbesondere auch die Anordnungen nach den Ansprüchen 9 bis 11 einfach realisierbar sind.

Alle angegebenen Verfahren sind für III-V-Halbleitermaterialien und für epitaktische Herstellung geeignet. Das Verfahren nach Anspruch 12 hat den Vorteil, daß für die Herstellung nur ein Epitaxieschritt erforderlich ist. Bei den Verfahren nach den Ansprüchen 13 und 14 sind zwar zwei Epitaxieschritte erforderlich, jedoch lassen sich mit ihnen integriert-optische Anordnungen mit reduzierter Polarisationsdispersion einfach herstellen. Das Verfahren nach Anspruch 14 unterscheidet sich vom Verfahren nach Anspruch 15 lediglich dadurch, daß die beiden erforderlichen Epitaxieschritte in der Reihenfolge vertauscht sind.

Mit dem Verfahren nach Anspruch 15 lassen sich auf einfache Weise die Wellenleiterstrukturen nach den Ansprüchen 9 und 10 gleichzeitig herstellen. In diesen Ansprüchen bedeutet Streifenwellenleiter einen Wellenleiter, bei dem die Breite des streifenartigen Wellenleiters durch die Breite der wellenleitenden Schicht selbst bestimmt ist, während Rippenwellenleiter bedeutet, daß die Breite des streifenartigen Wellenleiters durch die Breite der eine Rippe bildenden Deckschicht auf der wellenleitenden Schicht definiert ist. Streifenartiger Wellenleiter soll bedeuten, daß der Wellenleiter länger als breit ist und die optische Welle im wesentlichen nur in Längsrichtung dieses Wellenleiters geführt ist.

Ausführungsbeispiele der Erfindung werden anhand der Figuren in der nachfolgenden Beschreibung näher erläutert. Es zeigen:
- Figur 1: eine Draufsicht auf ein erstes Ausführungsbeispiel einer erfindungsgemäßen integriert-optischen Anordnung,
- Figur 2: den in Figur 1 gestrichelt umrandeten Ausschnitt A in vergrößerter Darstellung,
- Figur 3: den in Figur 1 gestrichelt umrandeten Bereich B in vergrößerter Darstellung,
- Figur 4: einen ausschnittsweisen Querschnitt durch das Ausführungsbeispiel längs der Schnittlinie IV-IV in Figur 2, wobei ein Auskoppelwellenleiter und ein Einkoppelwellenleiter nebeneinander gezeigt sind,

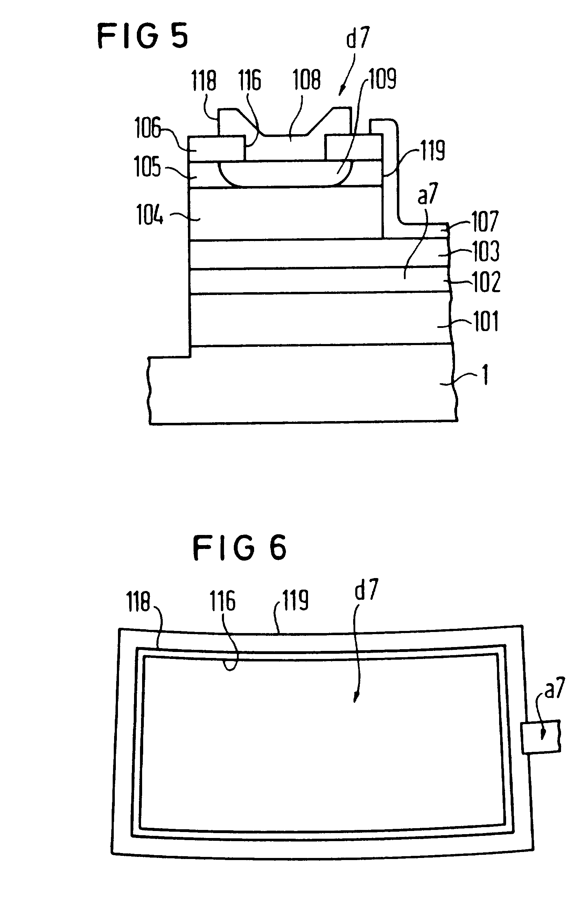

- Figur 5: einen ausschnittsweisen Schnitt durch das Ausführungsbeispiel nach Figur 1 längs der Schnittlinie V - V in Figur 3 in vergrößerter Darstellung, der einen Längsschnitt durch einen optischen Detektor und den daran angekoppelten Auskoppelwellenleiter zeigt,
- Figur 6: einen in Figur 3 dargestellten optischen Detektor mit angekoppeltem Auskoppelwellenleiter in nochmals vergrößerter Darstellung, und
- Figur 7: eine Draufsicht auf ein anderes Ausführungsbeispiel einer erfindungsgemäßen integriert-optischen Anordbei welcher ein bidirektionaler Betrieb möglich ist.

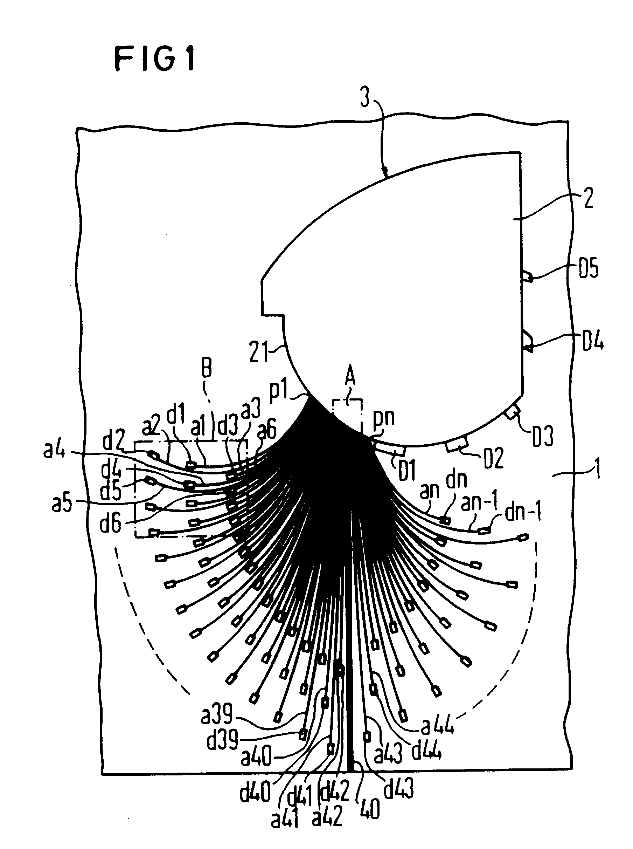

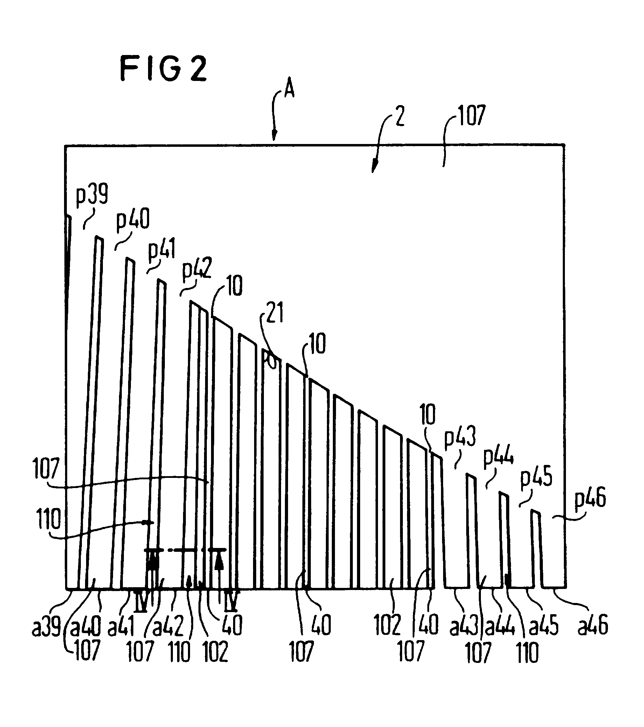

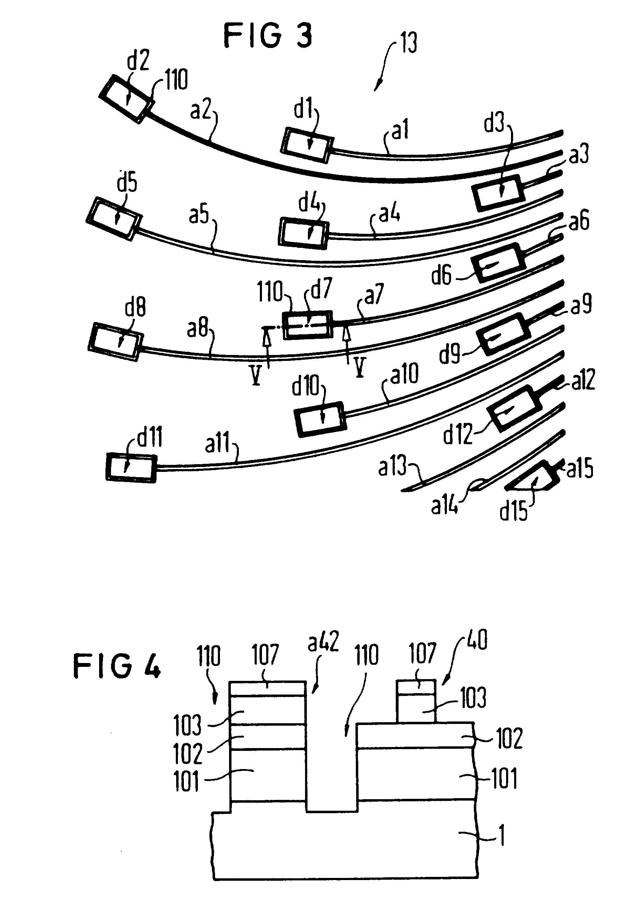

Bei dem Beispiel nach Figur 1 sind auf dem Substrat 1 der Schichtwellenleiter 2 mit dem Beugungsgitter 3, mehreren Einkoppelwellenleitern 40, eine Vielzahl von Auskoppelwellenleitern a1 bis an und eine Vielzahl von optischen Detektoren d1 bis dn integriert. Gemäß dem in Figur 2 dargestellten Ausschnitt A führen zehn nebeneinander laufende Eingangswellenleiter 40 zu jeweils einem Einkoppelpunkt 10 auf dem Rand 21 des Schichtwellenleiters 2. Gemäß Figur 4 sind beispielsweise die Einkoppelwellenleiter 40 in Form von Rippenwellenleitern und die Auskoppelwellenleiter a1 bis an in Form von Streifenwellenleitern ausgeführt.

Jeder Auskoppelwellenleiter führt von einem ihm zugeordneten Auskoppelpunkt p1 bis pn zu einem ihm zugeordneten optischen Detektor d1 bis dn.

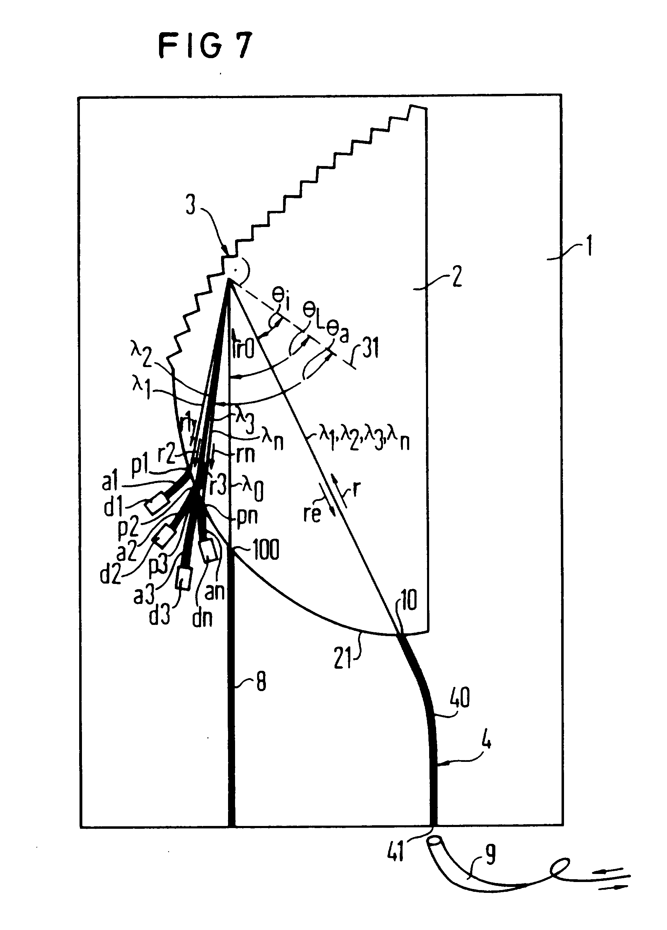

In den Figuren bedeutet n eine beliebige natürliche Zahl. Im Falle der Wellenlängenkanäle λ₁ bis λₙ bedeutet n die Anzahl dieser zu multiplexenden Kanäle. In den Figuren 1 und 7 bedeutet n die Anzahl der optischen Detektoren und der Auskoppelwellenleiter. Um n Wellenlängenkanäle demultiplexen zu können, müssen mindestens n Auskoppelwellenleiter und mindestens n optische Detektoren vorhanden sein. In der Figur 1 sind n = 63 Auskoppelwellenleiter und n = 63 optische Detektoren, die mit den Auskoppelwellenleitern verbunden sind, auf dem Substrat 1 integriert.

Die zu demultiplexenden Wellenlängenkanäle λ₁ bis λₙ werden in einen Einkoppelwellenleiter 40 eingekoppelt und zum zugeordneten Einkoppelpunkt 10 geführt, bei dem sie in den Schichtwellenleiter 2 eingekoppelt werden. Im Schichtwellenleiter 2 werden die Wellenlängenkanäle λ₁ bis λₙ zu einem Beugungsgitter geführt, das auf einem Abschnitt des Randes 21 des Schichtwellenleiters 2 ausgebildet ist. Das Gitter 3 ist vorzugsweise ein fokussierendes Gitter, bei dem der betreffende Abschnitt des Randes 21 längs einer gekrümmten Linie Sägezahnförmig verläuft, so wie es in der Figur 7 nicht maßstäblich und übertrieben dargestellt ist.

Das Gitter zerlegt die zugeführten Wellenlängenkanäle λ₁ bis λₙ spektral. Die vom Gitter spektral zerlegten Kanäle λ₁ bis λₙ werden vom Schichtwellenleiter 2 in Richtung zu den Auskoppelwellenleitern a1 bis an am Rand 21 des Schichtwellenleiters 2 geführt. Das fokussierende Gitter 3 bewirkt, daß jeder Wellenlängenkanal auf einen zugeordneten Auskoppelpunkt auf dem Rand des Schichtwellenleiters 21 fokussiert wird. Der an diesen Auskoppelpunkt angekoppelte Auskoppelwellenleiter wirkt wie eine Austrittsspalte bei einem Spektrographen und entspricht einem Wellenlängenkanal. Die Breite der Auskoppelwellenleiter bzw. der Abstand der Auskoppelwellenleiter legen die Kanalbreite bzw. den Kanalabstand fest.

Jeder Auskoppelwellenleiter führt den in ihn eingekoppelten Wellenlängenkanal dem optischen Detketor zu, mit dem er verbunden ist. Der optische Detektor detektiert diesen Kanal.

Im folgenden wird beispielhaft ein Verfahren zur Herstellung des Ausführungsbeispiels nach Figur 1 beschrieben:
Auf ein Substrat 1 aus InP wird ein Schichtpaket aufgebracht, das aus einer unmittelbar auf dem Substrat 1 aufgebrachten, aber nicht immer erforderlichen Pufferschicht 101 aus InP, aus einer wellenleitenden Schicht 102 aus InGaAsP auf der Pufferschicht 101, einer Deckschicht 103 aus InP auf der wellenleitenden Schicht 102, einer Absorptionsschicht 104 aus InGaAs auf der Deckschicht 103 und einer Kontaktschicht 105 aus InP auf der Absorptionsschicht 104. Auf die Kontaktschicht 105 wird eine Passivierungsschicht, beispielsweise aus SiNₓ aufgebracht, die mittels eines CVD-Verfahrens erzeugt werden kann.

In einer ersten Strukturebene wird an für die optischen Detektoren in Form von Photodioden vorgesehenen lokalen Bereichen eine lokale Dotierung 109 vorgenommen, die bei n-dotiertem Substrat 1 eine p-Dotierung und p-dotiertem Substrat 1 eine n-Dotierung ist. Diese Dotierung kann mittels Diffusion oder Ionenimplantation erfolgen. Diese erste Strukturebene kann entfallen, wenn die Kontaktschicht 105 in der Epitaxie bereits dotiert hergestellt wird. Dies führt zu einem einfacheren Aufbau, aber auch zu Stabilitätsproblemen der Photodiode, da der pn-Übergang am Heteroübergang an der Flanke des bei diesem Verfahren erzeugten mesaförmigen erhabenen Bereichs 119 offenliegt.

In einer zweiten Strukturebene wird in den lokalen Bereichen die dotierte Kontaktschicht 105 kontaktiert. Beispielsweise werden Kontaktpads 108 aus TiPtAu strukturiert, die beispielsweise mittels bekannter Abhebetechnik hergestellt werden und die Kontaktschicht 105 durch eine Öffnung 116 in der Passivierungsschicht 106 kontaktieren.

In einer dritten Strukturebene werden mit Hile der Passivierungsschicht 106 als Maske die mesaförmigen erhabenen Bereiche 119 durch eine Ätzung bis hinab zur Deckschicht 103 hergestellt. Diese Ätzung kann beispielsweise durch reaktives Ionenätzen (RIE), beispielsweise mit CH₄/H₂ vorgenommen werden.

Bei einer fünften Strukturierungsebene werden der Schichtwellenleiter 2, das Gitter 3 und die Eingangs- und Ausgangswellenleiter 40 bzw. a1 bis an mit Hilfe einer Maskenschicht 107 definiert. Diese Maskenschicht 107 kann eine Passivierungsschicht sein, die auf der Anordnung verbleibt. Beispielsweise kann die Maskenschicht 107 aus SiNₓ bestehen, das mittels eines CVD-Verfahrens aufgebracht wird.

Die Struktur der Maskenschicht 107 ist in der Figur 2 in Draufsicht gezeigt.

Vor der Ätzung der vierten Strukturebene wird zunächst in einer fünften Strukturebene die Maskenschicht 107 der Einkoppelwellenleiter 40 mit einer nicht dargestellten zweiten Maskenschicht abgedeckt, die seitlich der Maskenschicht 107 liegende Bereiche der Deckschicht 103 mit abdeckt. Diese zweite Maskenschicht kann beispielsweise aus Photolack bestehen.

Danach wird in dem von der Maskenschicht 107 und der zweiten Maskenschicht freien Bereichen eine Ätzung bis in eine unter der wellenleitenden Schicht 102 liegenden Tiefe vorgenommen. Auch für diese Ätzung ist RIE mit CH₄/H₂ geeignet. Nach dem Entfernen der zweiten Maskenschicht, beispielsweise durch Veraschen in O₂ ⁺ werden die Einkoppelwellenleiter 40 durch Ätzen der freiliegenden seitlichen Bereiche der Deckschicht 103 als Rippenwellenleiter geätzt. Auch dies kann mittels RIE mit CH₄/H₂ vorgenommen werden. Bei diesem Schritt werden auch die übrigen Wellenleiter 2 und a1 bis an sowie das Beugungsgitter 3 tiefer geätzt.

In einer sechsten Strukturebene werden schließlich die geätzten Stirnflächen des Beugungsgitters 3 mit Metall bedampft, um den Beugungswirkungsgrad des Gitters zu erhöhen. Dies kann mittels bekannter Abhebetechnik erfolgen.

Bei dem beispielhaften Herstellungsverfahren ist das Schichtpaket so dimensioniert, daß es in einer Epitaxie mit der Photodiode zusammen hergestellt werden kann. Die Gap-Wellenlänge des Materials der wellenleitenden Schicht, die 1,05 µm beträgt, hält die Polarisationsdispersion gering.

Bei einer mit dem beispielhaften Verfahren hergestellten Anordnung hat die Pufferschicht 101 eine Dicke von mehr als 2 µm. Die wellenleitende Schicht 102 hat eine Gap-Wellenlänge von 1,05 µm und eine Dicke von 0,5 µm. Die Dicke der Deckschicht 103 beträgt 0,2 µm. Die Dicke der Absorptionsschicht beträgt 1 µm und die Dicke der Kontaktschicht 0,5 µm. Alle diese Schichten werden in einem Epitaxieschritt aufgebracht.

Das Substrat 1 aus InP kann n-dotiert oder zur Erzielung besserer HF-Eigenschaften semi-isolierend sein. Bei Verwendung des semi-isolierenden Substrats 1 wird in der unteren Hälfte der Pufferschicht 101 n-dotiert, um einen niederohmigen Anschluß des n-Gebietes der Photodioden zu ermöglichen. Außerdem werden zusätzliche Strukturschritte erforderlich, um den n-Kontakt zu definieren und die p-Kontakte auf das semi-isolierende Substrat hinauszuziehen. Die Version mit dem n-dotierten Substrat 1 ist technologisch einfacher.

Die Breite der einmodigen Einkoppelwellenleiter 40 ist bei einer Rippenhöhe von 0,2 µm so gewählt, daß das Licht am Einkoppelpunkt 10 mit einem möglichst großen Divergenzwinkel von beispielsweise ± 10° austritt, um möglichst viele Gitterzähne zu beleuchten, was eine hohe Auflösung bedeutet. Beim Lichteinkoppeln in benachbarte Einkoppelwellenleiter 40 kann eine Verschiebung des Spektrums an den Photodioden d1 bis dn erreicht werden und so durch Auswahl eines geeigneten Einkoppelwellenleiters 40 eine gewünschte Zentralwellenlänge auf eine Photodiode gelegt werden.

Das gekrümmte Beugungsgitter 3 ist so dimensioniert, daß es bei der gegebenen Auflösung des Lithographieverfahrens eine möglichst große Dispersion in möglichst kleiner Ordnung der Anordnung ermöglicht. Der Abschnitt des Randes 21 des Schichtwellenleiters 2, auf dem die Auskoppelpunkte p1 bis pn liegen, ist ein Kreisbogen, der dem Rowlandkreis entspricht.

Der Abstand der Auskoppelwellenleiter ist mit etwa 10 µm für einen Kanalabstand von 4 nm gewählt. Die Breite der Auskoppelwellenleiter ist mit 9 µm so groß wie möglich gewählt.

Die Auskoppelwellenleiter a1 bis an sind auf Kreisbögen mit einem Radius von mehr als 1 mm auseinandergeführt, bis der Abstand dieser Wellenleiter so groß ist, daß Bondpads mit einer Fläche von 50x100 µm auf den Photodioden Platz haben. Bei Verwendung eines semi-isolierenden Substrats können die Photodioden schmäler ausgeführt werden, da die Bondpads nicht mehr auf der Photodiode selbst liegen. Der erforderliche Abstand der Auskoppelwellenleiter voneinander ergibt sich in diesem Fall aus der Führung der Leiterbahnen von den p-Kontakten zu den Bondpads und deren Lage auf dem Substrat. Die Pads lassen sich durch Wedge Bonding verdrahten.

Die Photodioden d1 bis dn sind in drei hintereinander liegenden Reihen angeordnet um erstens Platz zu sparen und um gleichzeitig einen möglichst großen Abstand der Pads zu gewährleisten, durch den elektrisches Nebensprechen unterdrückt wird.

Bei dem Beispiel beträgt die minimal auflösbare Gitterperiode 1,6 µm. Bei dieser Auflösung ist eine Dispersion von 1 mrad/nm in der vierten Ordnung der Anordnung ermöglicht. Das Licht, das vom Beugungsgitter 3 in vierter Ordnung in die nullte, erste, zweite oder dritte Ordnung gebeugt wird, wird ebenfalls in der Nähe des Rowlandkreises fokussiert. Dieses Licht kann in Photodioden D1 bis D5 nachgewiesen werden.

Diese Photodioden D1 bis D5 können wie die Photodioden d1 bis dn hergestellt werden und erhalten ein Referenzsignal, das der Summe der empfangenen Kanäle entspricht. Die Intensität der Signale gibt Aufschluß über den Beugungswirkungsgrad des Gitters 3 in die einzelnen Ordnungen.

Die Breite der Photodioden d1 bis dn ist durch die Größe des Bondpads bestimmt, wenn dieser auf der Diode selbst liegt. Andernfalls haben sie eine Mindestbreite von etwa 15 µm.

Die Polarisationsdispersion läßt sich durch eine dickere Deckschicht 103 mit einer Dicke von etwa 1 µm auf etwa 0,7 nm verringern. Eine weitere Reduzierung der Dispersion ist durch eine anschließende Beschichtung dieser Deckschicht mit Metall zu erreichen (siehe deutsche Patentanmeldung P 39 31 705.6).

Um eine dispersionsreduzierende dicke Deckschicht 103 verwenden und trotzdem einen guten Wirkungsgrad der Photodiode d₁ bis dₙ erhalten zu können, wird das vorstehend angegebene Beispiel des Herstellungsverfahrens so abgewandelt, daß in einer Zweifach-Epitaxie ein eigenes Schichtpaket für die Wellenleiter 2, a1, ... an, 40 und ein eigenes Schichtpaket für die Photodioden (d1 bis dn) gewachsen werden.

Im ersten Epitaxieschritt wird auf dem Substrat die Pufferschicht 101, die wellenleitende Schicht 102, und die Deckschicht 103 mit einer Dicke von 1 µm aufgewachsen. Diese Deckschicht 103 wird in einem nullten Strukturierungsschritt überall dort maskiert, wo nur die Wellenleiter 2, a1 bis an, 40 entstehen sollen. Dann wird durch selektives Ätzen, beispielsweise in HCL die dicke Deckschicht 103 aus InP überall sonst bis zur wellenleitenden Schicht 102 aus InGaAsP entfernt.

Im zweiten Epitaxieschritt wird dann das Schichtpaket für die Photodioden auf die freigelegte wellenleitende Schicht 102 selektiv aufgewachsen. Dieses Schichtpaket besteht aus einer Absorptionsschicht 104 aus InGaAs mit einer Dicke von 1 µm und aus einer Kontaktschicht 105 aus InP mit einer Dicke von 0,5 µm.

Die beiden Epitaxieschritte können auch in umgekehrter Reihenfolge ausgeführt werden, je nachdem welche Reihenfolge sich als technologisch günstiger erweist.

Im weiteren wird die horizontale Strukturierung wie bei dem zuerst angegebenen Herstellungsbeispiel vorgenommen, wobei mit der ersten Strukturebene begonnen wird.

Der Spektralbereich einer durch die vorstehenden Herstellungsbeispiele hergestellten Anordnung liegt bei 1,3 µm bis 1,6 µm. Bei einem Kanalabstand von 4 nm sind bis zu 100 Kanäle verfügbar. Durch die monolithische Integration von Demultiplexer und Photodioden entfallen aufwendige und empfindliche Justierungen bei dieser Anordnung, die daher als Empfängerbaustein für DWDM-Systeme geeignet ist.

Die in Figur 7 schematisch dargestellte erfindungsgemäße Anordnung ist für bidirektionalen Betrieb geeignet und unterscheidet sich von der Anordnung nach Figur 1 im wesentlichen durch einen oder mehrere zusätzliche optische Sender 8, wobei der Einfachheit halber nur ein Sender 8 dargestellt ist.

Die Anordnung nach Figur 7 kann für ein bidirektionales Teilsystem beim Teilnehmer eingesetzt werden. Die Anordnung sendet bei einer oder mehreren Wellenlängen und empfängt und demultiplext mehrere Wellenlängekanäle, wobei die Sende- und Empfangswellenlängen relativ weit getrennt liegen. Beispielsweise senden die Sender 8 bei einer Wellenlänge λ₀ in einem Bereich bei 1,5 µm und der Empfänger im Bereich von 1,28 µm bis 1,38 µm bei einem Kanalabstand Δ λ von 4 nm.

Das vom Empfänger über eine Streckenfaser 9 zugeführte Licht wird von dem als optischer Verstärker 4 ausgebildeten Einkoppelwellenleiter 40 zum Einkoppelpunkt 10 auf dem Rand 21 des Schichtwellenleiters 2 geführt und am Einkoppelpunkt 10 in den Schichtwellenleiter 2 eingekoppelt. Im Schichtwellenleiter 2 breitet sich das Licht lateral mit einem Öffnungswinkel gemäß der Breite des Einkoppelwellenleiters 40 frei in Richtung r aus und trifft auf das Beugungsgitter 3, von dem das Licht auf die Auskoppelpunkte p1 bis pn fokussiert wird.

Wie bei dem Ausführungsbeispiel nach Figur 1 führen die an den Auskoppelpunkten p1 bis pn an den Schichtwellenleiter frei angekoppelten Aufkoppelwellenleiter a1 bis an die verschiedenen Wellenlängenkanäle λ₁ bis λₙ zu Photodioden d1 bis dn. Diese Photodioden d1 bis dn sind zweckmäßigerweise aus InGaAsp mit einer Gatwellenlänge von etwa 1,4 µm hergestellt, so daß das Licht der Wellenlängenkanäle im Bereich von 1,28 bis 1,38 µm absorbiert wird, das Licht der optischen Sender 8 im Wellenlängenbereich bei 1,5 µm dagegen transmittiert und somit nicht in einen Photostrom verwandelt wird.

Das Beugungsgitter ist bezüglich des vorzugsweise in Form eines Halbleiterlasers ausgebildeten optischen Senders 8 in Littrow-Anordnung mit einer Littrow-Wellenlänge. Die Halbleiterlaser des jeweiligen Sendekanals sind mit einer aktiven Schicht für etwa 1,53 µm Emissionswellenlänge ausgeführt. Die optischen Resonatoren sind auf der einen Seite durch eine Endfläche oder einen geätzten Spiegel begrenzt und auf der anderen Seite durch das Gitter, das für Licht der Sendewellenlänge einen teilreflektierenden Spiegel darstellt. Eine andere Ordnung des Beugungsgitters 3 fokussiert das Licht der Sendewellenlänge in Richtung re zum Einkoppelpunkt 10, wo dieses Licht in den Einkoppelwellenleiter 40 eingekoppelt wird.

Um Herstellungstoleranzen auszugleichen, können ähnlich wie bei den Einkoppelwellenleitern 40 nach Figur 1 mehrere Laser 8 nebeneinander angeordnet werden, so daß auf jeden Fall die Emissionswellenlänge eines Lasers bei der Littrow-Wellenlänge des Beugungsgitters 3 liegt.

Zur Erhöhung der Nachweisempfindlichkeit der Anordnung nach Figur 7 und um die Verluste des Beugungsgitters 3 auszugleichen, ist der Einkoppelwellenleiter 40 als optischer Verstärker 4 für den Wellenlängenbereich um 1,3 µm ausgeführt.

Ebenfalls um die Nachweisempfindlichkeit zu erhöhen ist die Stirnfläche 41 des Einkoppelwellenleiters 4 für den Wellenlängenbereich 1,28 bis 1,38 µm entspiegelt. Der Wirkungsgrad des Lasers kann erhöht werden, wenn die Entspiegelungsschicht an dieser Stirnfläche 41 als Verspiegelung 1,53 µm wirkt. Eine derartige Stirnflächenbeschichtung besteht zum Beispiel aus zwei unterschiedlich brechenden Schichten verschiedener Dicke.

Bei einem nichtbeschränkenden Ausführungsbeispiel des Beugungsgitters 3 ist das Gitter wie folgt dimensioniert: Die Gitterperiode beträgt 1,5 µm der Winkel θ_{L} zwischen der Emissionsrichtung r₀ und der Gitternormalen 31 beträgt in der fünften Beugungsordnung (kein Glanzwinkel) 52,36°. Die vierte Ordnung für das Licht der Wellenlänge 1,53 µm wird dann vom Gitter 3 in einer Richtung re zum Einkoppelpunkt 10 abgestrahlt, die einen Winkel θᵢ von 28,36° mit der Gitternormalen 31 einschiebt. Dies bedeutet fast Glanzwinkel.

Das am Einkoppelpunkt 10 in den Schichtwellenleiter 2 eingekoppelte Licht der Wellenlänge 1,3 µm trifft in einer Richtung r auf das Gitter 3, die mit der Gitternormalen 31 den gleichen Winkel θᵢ von 28,36° einschließt. Dieses Licht wird in fünfter Ordnung in einer Hauptrichtung zu den Auskoppelpunkten p1 bis pn abgestrahlt, die mit der Gitternormalen 31 einen Winkel θₐ von 60,54° einschließt (Glanzwinkel). Das Licht der Wellenlänge 1,3 µm wird in vierter Ordnung unter einem Winkel von etwa 37° mit einem wesentlich kleineren Beugungswirkungsgrad abgestrahlt (kein Glanzwinkel).

Das Gitter erhält einen Glanz- oder Blaze-Winkel, so daß die Kopplung von Licht der Wellenlänge um 1,3 µm aus dem Einkoppelwellenleiter 40 in die Photodiode d1 bis dn optimiert wird. Dafür wird die den Glanz erzeugende Fläche der Gitterzähne unter einem Winkel von 44,45° zur Gitternormalen 31 abgestellt.

In der Figur 7 ist der Einfachheit halber n = 4 gewählt.

## Patentansprüche

1. Integriert-optische Anordnung zum Demultiplexen mehrerer verschiedener optischer Wellenlängen (λ₁, λ₂, ... λₙ) mit einem auf einem Substrat (1) integrierten und durch eine Stufe (21) begrenzten Schichtwellenleiter (2), der ein auf der Stufe (21) senkrecht zum Schichtwellenleiter (2) ausgebildetes optisches Beugungsgitter (3) aufweist,
- wobei die Wellenlängen (λ₁, λ₂ ...λₙ) an zumindest einem diesen Wellenlängen (λ₁, λ₂, ...λₙ) gemeinsamen zugeordneten Einkoppelpunkt (10) auf der Stufe (21) in die wellenleitende Schicht (2) einkoppelbar sind,
- wobei diese eingekoppelten Wellenlängen (λ₁, λ₂, ...λₙ) in der wellenleitenden Schicht (2) zum Beugungsgitter (3) geführt sind,
- wobei das Beugungsgitter (3) die ihm zugeführten Wellenlängen (λ₁, λ₂, ...λₙ) durch Abbeugen in verschiedene Richtungen (r1, r2, ... rn) räumlich voneinander trennt,
- wobei jede vom Beugungsgitter (3) getrennte Wellenlänge (λ ₁, λ₂, ...λₙ) im Schichtwellenleiter (2) zu je einem von mehreren räumlich voneinander getrennten Auskoppelpunkten (p1, p2, ..pn) auf der Stufe (21) geführt ist, und
- wobei an jedem Auskoppelpunkt (p1, p2, ... pn) die zugeführte Wellenlänge (λ₁, λ₂, ...λₙ) aus dem Schichtwellenleiter (2) auskoppelbar ist,
- wobei eine Wellenlänge (λ₁, λ₂, ...λₙ) dem zumindest einen Einkoppelpunkt (10) durch einen Einkoppelwellenleiter (40) in Form eines auf dem Substrat (1) integrierten streifenartigen optischen Wellenleiters zugeführt ist und
- wobei an einem Auskoppelpunkt (p1, p2, ... pn) ein in Form eines auf dem Substrat (1) integrierten streifenartigen optischen Wellenleiters ausgebildeter Auskoppelwellenleiter (a1, a2,... an) optisch angekoppelt ist, der die aus diesem Auskoppelpunkt (p1, p2, ... pn) ausgekoppelte Wellenlänge (λ₁, λ₂, ...λₙ) fortführt,
**dadurch gekennzeichnet**,
daß der Auskoppelwellenleiter (a1, a2, ... an) zu einem auf dem Substrat (1) integrierten optischen Detektor (d1, d2, ... dn) führt und daß auf dem Substrat (1) mindestens ein optischer Verstärker (4) integriert ist, der eine oder mehrere der den optischen Detektoren (d1, d2, ... dn) zuzuführende Wellenlänge (λ₁, λ₂ ...λₙ) optisch verstärkt.

2. Anordnung nach Anspruch 1,
**dadurch gekennzeichnet**,
daß das Beugungsgitter (3) in Form eines fokussierenden optischen Gitters ausgebildet ist, das die abgebeugten Wellenlängen (λ₁, λ₂, ...λₙ) auf die Auskoppelpunkte (p1, p2, ... pn) fokussiert.

3. Anordnung nach einem der vorhergehenden Ansprüche,
**dadurch gekennzeichnet**,
daß ein optischer Verstärker (4) in einem Einkoppelwellenleiter (40) und/oder in einem Auskoppelwellenleiter ((al, a2, ... an) ausgebildet ist.

4. Anordnung nach einem der vorhergehenden Ansprüche,
**dadurch gekennzeichnet**,
daß von den Auskoppelpunkten (p1, p2, ... pn) zu verschiedenen optischen Detektoren (d1, d2, ... dn) führende Auskoppelwellenleiter (a1, a2, ... an) räumlich voneinander divergieren.

5. Anordnung nach einem der vorhergehenden Ansprüche,
**dadurch gekennzeichnet**,
daß ein optischer Detektor (d1, d2, ... dn) in Form einer Photodiode ausgebildet ist, die optisch durch Leckwellenkopplung an den zu dieser Diode führenden Auskoppelwellenleiter (a1, a2, ... an) gekoppelt ist.

6. Anordnung nach einem der vorhergehenden Ansprüche,
**gekennzeichnet durch**
wenigstens einen auf dem Substrat (1) integrierten optischen Sender (8) zur Erzeugung einer einzelnen optischen Wellenlänge (λ₀), die an einem von dem zumindest einen Einkoppelpunkt (10) verschiedenen anderen Einkoppelpunkt (100) auf der Stufe (21) in den Schichtwellenleiter (2) einkoppelbar ist, wobei die eingekoppelte einzelne Wellenlänge (λ₀) im Schichtwellenleiter (2) zum Beugungsgitter (3) geführt ist, wobei das Beugungsgitter (3) die einzelne Wellenlänge (λ₀) in Richtung (re) zu dem einen Einkoppelpunkt (10) abbeugt, und wobei die abgebeugte einzelne Wellenlänge (λ₀) im Schichtwellenleiter (2) zu dem einen Einkoppelpunkt (10) geführt und an diesem Einkoppelpunkt (10) aus dem Schichtwellenleiter (2) auskoppelbar ist.

7. Anordnung nach Anspruch 6,
**dadurch gekennzeichnet**,
daß der optische Sender (8) in Form eines oder mehrerer Halbleiterlaser ausgebildet ist.

8. Anordnung nach Anspruch 6 oder 7,
**dadurch gekennzeichnet**,
daß das Beugungsgitter (3) in Form eines fokussierenden optischen Gitters ausgebildet ist, das die abgebeugte einzelne Wellenlänge (λ₀) auf den einen Einkoppelpunkt (10) fokussiert.

9. Anordnung nach einem der vorhergehenden Ansprüche,
**dadurch gekennzeichnet**,
daß ein Ausgangswellenleiter (a1, a2, ... an) in Form eines Streifenwellenleiters ausgebildet ist.

10. Anordnung nach einem der vorhergehenden Ansprüche,
**dadurch gekennzeichnet**,
daß ein Einkoppelwellenleiter (40) in Form eines Rippenwellenleiters ausgebildet ist.

11. Anordnung nach einem der vorhergehenden Ansprüche,
**dadurch gekennzeichnet**,
daß ein optischer Detektor (d1, d2, ... dn) auf einem mesaförmig erhabenen Bereich (119) des Substrats (1) ausgebildet ist.

12. Verfahren zur Herstellung einer Anordnung nach Anspruch 5 oder Anspruch 5 und einem der Ansprüche 9 bis 11,
**dadurch gekennzeichnet**,
daß auf einem Substrat (1) ein Schichtpaket bestehend aus zumindest einer optisch wellenleitenden Schicht (102), einer die wellenleitende Schicht (102) abdeckenden Deckschicht (103), einer die Deckschicht (103) bedeckenden Absorptions-schicht (104) und einer die Absorptionsschicht (104) bedekkenden Kontaktschicht (105) erzeugt wird, wobei die Kontaktschicht (105) zumindest in für Photodioden (d1, d2, ... dn) vorgesehenen lokalen Bereichen mit einer im Vergleich zu einer unter der wellenleitenden Schicht (102) vorhandenen Dotierung entgegengesetzten Dotierung (109) versehen wird, daß die Kontaktschicht (105) in den lokalen Bereichen mit Kontakten (108) versehen und das Schichtpaket außerhalb der lokalen Bereiche durch Entfernen der Kontaktschicht (105) und Absorptionsschicht (104) bis zur Deckschicht (103) reduziert wird, so daß in den lokalen Bereichen mesaförmig aus der Deckschicht (103) ragende, die dotierte und kontaktierte Kontaktschicht (105) und Absorpionsschicht (104) auf weisende erhabene Bereiche (119) stehenbleiben, von denen jeder eine durch Leckwellenkopplung an die wellenleitende Schicht (102 gekoppelte Photodiode (d1, d2, ... dn) definiert, und daß im Bereich des reduzierten Schichtpaketes außerhalb der mesaförmig erhabenen Bereiche (119) der Schichtwellenleiter (2) mit der Stufe (21) und dem auf der Stufe ausgebildeten Beugungsgitter (3) sowie streifenartige Wellenleiter (a1, a2, ... an, 40) durch bereichsweise Entfernung der Deckschicht (103) und der wellenleitenden Schicht (102) derart erzeugt werden, daß im Bereich des Schichtwellenleiters (2) mit der Stufe (21) und den streifenartigen Wellenleitern (a1, a2, ... an, 40) die wellenleitende Schicht (102) und die Deckschicht (103) stehenbleiben.

13. Verfahren zur Herstellung einer Anordnung nach Anspruch 5 oder Anspruch 5 und einem der Ansprüche 9 bis 11,
**dadurch gekennzeichnet**,
daß auf einem Substrat (1) ein Schichtpaket bestehend aus einer optisch wellenleitenden Schicht (102) und einer die Wellenleitende Schicht (102) abdeckenden Deckschicht (103) erzeugt wird, daß die Deckschicht (103) im für Photodioden (d1, d2 ... dn) vorgesehenen lokalen Bereichen bis zur wellenleitenden Schicht (103) derart entfernt wird, daß die Deckschicht (103) außerhalb der lokalen Bereiche stehenbleibt, daß in den lokalen Bereichen auf die freigelegte wellenleitende Schicht (102) eine Absorptionsschicht (104) und auf der Absorptionsschicht (104) eine Kontaktschicht (105) mit einer im Vergleich zu einem unter der wellenleitenden Schicht (102) vorhandenen Dotierung entgegengesetzten Dotierung (109) erzeugt wird, und daß in den für Photodioden (d1, d2, ... dn) vorgesehenen lokalen Bereichen die dotierte Kontaktschicht (105) kontaktiert und außerhalb der lokalen Bereiche der Schichtwellenleiter (2) mit dem Beugungsgitter (3) und streifenartige Wellenleiter (a1, a2, ... an, 40) durch bereichsweises Entfernen der Deckschicht (103) und wellenleitenden Schicht (102) derart erzeugt werden, daß im Bereich der Wellenleiter (2, a1, a2 ... an, 40) die wellenleitende Schicht (102) und die Deckschicht (103) stehenbleiben.

14. Verfahren zur Herstellung einer Anordnung nach Anspruch 5 oder Anspruch 5 und einem der Ansprüche 9 bis 11,
**dadurch gekennzeichnet**,
daß auf einem Substrat ein Schichtpaket, bestehend zumindest aus einer optisch wellenleitenden Schicht (102), einer die wellenleitende Schicht (102) abdeckenden Absorptionsschicht (104) und einer die Absorptionsschicht abdeckenden Kontaktschicht (105) erzeugt wird, daß die Kontaktschicht (105) und die Absorptionsschicht (104) bereichsweise bis zur wellenleitenden Schicht (102) derart entfernt wird, daß die Absorptionsschicht (104) und die Kontaktschicht (105) in für Photodioden (d1, d2, ... dn) lokalen Bereichen stehenbleiben, daß außerhalb der lokalen Bereiche die wellenleitende Schicht (102) mit einer Deckschicht (103) abgedeckt wird, daß in den für Photodioden (d1, d2, ... dn) vorgesehenen lokalen Bereichen, die mit einer im Vergleich zu einer unter der wellenleitenden Schicht (102) vorhandenen Dotierung entgegengesetzten Dotierung (109) versehene Kontaktschicht (105) kontaktiert wird, und daß der außerhalb der lokalen Bereiche der Schichtwellenleiter (2) mit dem Beugungsgitter (3) und streifenartige Wellenleiter (a1, a2, ... an, 40) durch bereichsweise Entfernung der Deckschicht (103) und wellenleitenden Schicht (102) derart erzeugt werden, daß im Bereich der Wellenleiter (2,a1, a2 ... an, 40) die wellenleitende Schicht (102) und die Deckschicht (103) stehenbleiben.

15. Verfahren nach Anspruch 12, 13 oder 14 zur Herstellung einer Anordnung nach Anspruch 9 oder 10,
**dadurch gekennzeichnet**,
daß zum Bereichsweisen Entfernen der Deckschicht (103) und der wellenleitenden Schicht (102) die Deckschicht (103) mit einer Maskenschicht (107) abgedeckt wird, welche den Schichtwellenleiter (2) mit dem Beugungsgitter (3) und die Streifenartigen Wellenleiter (a1, a2, ... an, 40) definierend abdeckt, daß eine einen Einkoppelwellenleiter (40) definierende Maskenschicht (107) mit einer zweiten Maskenschicht abgedeckt wird, die seitliche Bereiche der Deckschicht (103) mit abdeckt, daß die Deckschicht (103) und die wellenleitende Schicht (103) bereichsweise derart entfernt werden, daß die Deckschicht (103) und wellenleitende Schicht (102) unter der Maskenschicht (107) und zweiten Maskenschicht stehenbleibt, daß die zweite Maskenschicht entfernt wird, und daß die Deckschicht (103) in dem von der zweiten Maskenschicht mit abgedeckten und jetzt freiliegenden seitlichen Bereich derart bis zur wellenleitenden Schicht (102) entfernt wird, daß die Deckschicht (103) unter der Maskenschicht (107) stehenbleibt.

## Claims

1. Integrated-optical arrangement for demultiplexing a plurality of various optical wavelengths (λ₁, λ₂, ...λₙ), having a layer waveguide (2), which is integrated on a substrate (1), is bounded by a step (21) and has a diffraction grating (3) which is constructed on the step (21) at right angles to the layer waveguide (2),
- the wavelengths (λ₁, λ₂, ...λₙ) being able to be coupled into the waveguiding layer (2) at at least one common input coupling point (10) assigned to these wavelengths (λ₁, λ₂, ...λₙ),
- these wavelengths (λ₁, λ₂, ...λₙ) that are coupled in being guided in the waveguiding layer (2) to the diffraction grating (3),
- the diffraction grating (3) spatially separating the wavelengths (λ₁, λ₂, ...λₙ) fed to it by diffraction in various directions (r1, r2, ... rn),
- each wavelength (λ₁, λ₂, ...λₙ) separated by the diffraction grating (3) being guided in the layer waveguide (2) in each case to one of a plurality of spatially mutually separated output coupling points (pl, p2, ... pn) on the step (21), and
- at each output coupling point (p1, p2, ... pn) the wavelength (λ₁, λ₂, ...λₙ) that is fed being able to be coupled out of the layer waveguide (2),
- one wavelength (λ₁, λ₂, ...λₙ) being fed to the at least one input coupling point (10) by an input coupling waveguide (40) in the form of a strip-like optical waveguide integrated on the substrate (1) and
- at an output coupling point (p1, p2, ... pn), an output coupling waveguide (a1, a2, ... an) constructed in the form of a strip-like optical waveguide integrated on the substrate (1) being optically coupled and leading away the wavelength (λ₁, λ₂, ...λₙ) that is coupled out from this output coupling point (p1, p2, ... pn),
characterized in that the output coupling waveguide (a1, a2, ... an) leads to an optical detector (d1, d2 ... dn) that is integrated on the substrate (1), and in that there is integrated on the substrate (1) at least one optical amplifier (4) which optically amplifies one or more of the wavelengths (λ₁, λ₂, ...λₙ) to be fed to the optical detectors (d1, d2, ... dn).

2. Arrangement according to Claim 1, characterized in that the diffraction grating (3) is constructed in the form of a focusing optical grating that focuses the diffracted wavelengths (λ₁, λ₂, ...λₙ) on the output coupling points (p1, p2, ... pn).

3. Arrangement according to one of the preceding claims, characterized in that an optical amplifier (4) is constructed in an input coupling waveguide (40) and/or in an output coupling waveguide (a1, a2, ... an).

4. Arrangement according to one of the preceding claims, characterized in that output coupling waveguides (a1, a2, ... an), leading from the output coupling points (p1, p2, ... pn) to various optical detectors (d1, d2, ... dn), diverge spatially from one another.

5. Arrangement according to one of the preceding claims, characterized in that an optical detector (d1, d2, ... dn) is constructed in the form of a photodiode which is optically coupled via leakage wave coupling to the output coupling waveguide (a1, a2, ... an) leading to this diode.

6. Arrangement according to one of the preceding claims, characterized by at least one optical transmitter (8) that is integrated on the substrate (1) for generating a single optical wavelength (λ₀), which can be coupled into the layer waveguide (2) at an input coupling point (100), which is different from the at least one input coupling point (10), on the step (21), the coupled-in single wavelength (λ₀) being guided in the layer waveguide (2) to the diffraction grating (3), the diffraction grating (3) diffracting the single wavelength (λ₀) in the direction (re) of the one input coupling point (10), and the diffracted single wavelength (λ₀) being guided in the layer waveguide (2) to the one input coupling point (10) and being able to be coupled out of the layer waveguide (2) at this input coupling point (10).

7. Arrangement according to Claim 6, characterized in that the optical transmitter (8) is constructed in the form of one or more semiconductor lasers.

8. Arrangement according to Claim 6 or 7, characterized in that the diffraction grating (3) is constructed in the form of a focusing optical grating that focuses the diffracted single wavelength (λ₀) onto the one input coupling point (10).

9. Arrangement according to one of the preceding claims, characterized in that an output waveguide (a1, a2, ... an) is constructed in the form of a strip waveguide.

10. Arrangement according to one of the preceding claims, characterized in that an input coupling waveguide (40) is constructed in the form of a ribbed waveguide.

11. Arrangement according to one of the preceding claims, characterized in that an optical detector (d1, d2, ... dn) is constructed on a mesa-like, elevated region (119) of the substrate (1).

12. Method of manufacturing an arrangement according to Claim 5 or Claim 5 and one of Claims 9 to 11, characterized in that a packet of layers, comprising at least one optically waveguiding layer (102), a covering layer (103) covering the waveguiding layer (102), an absorption layer (104) covering the covering layer (103) and a contact layer (105) covering the absorption layer (104), is produced on a substrate (1), the contact layer (105) being provided, at least in local regions provided for photodiodes (d1, d2, ... dn), with a doping (109) which is opposite to a doping present under the waveguiding layer (102), in that the contact layer (105) is provided in the local regions with contacts (108) and the packet of layers is reduced outside the local regions by removing the contact layer (105) and absorption layer (104) down as far as the covering layer (103) so that, in the local regions, there remain elevated regions (119) which project mesa-like out of the covering layer (103) and have the doped and contacted contact layer (105) and absorption layer (104), each elevated region defining a photodiode (d1, d2, ... dn) that is coupled by leakage wave coupling to the waveguiding layer (102), and in that, in the region of the reduced packet of layers, outside the mesa-like elevated regions (119), the layer waveguide (2) having the step (21) and the diffraction grating (3) that is constructed on the step and the strip-like waveguides (a1, a2, ... an, 40) are produced by partial removal of the covering layer (103) and of the waveguiding layer (102) in such a way that, in the region of the layer waveguide (2) having the step (21), and the strip-like waveguides (a1, a2, ... an, 40), the waveguiding layer (102) and the covering layer (103) remain.

13. Method of manufacturing an arrangement according to Claim 5 or Claim 5 and one of Claims 9 to 11, characterized in that a packet of layers, comprising an optically waveguiding layer (102) and a covering layer (103) covering the waveguiding layer (102), is produced on a substrate (1), in that the covering layer (103) is removed, in the local regions provided for photodiodes (d1, d2, ... dn), as far as the waveguiding layer (103), in such a manner that the covering layer (103) remains outside the local regions, in that in the local regions, on the exposed waveguiding layer (102), an absorption layer (104) is produced and, on the absorption layer (104) a contact layer (105) is produced, having a doping (109) which is opposite to a doping which is present under the waveguiding layer (102), and in that, in the local regions provided for photodiodes (d1, d2, ... dn), the doped contact layer (105) is contacted and, outside the local regions, the layer waveguide (2) having the diffraction grating (3) and strip-like waveguides (a1, a2, ... an, 40) are produced by partial removal of the covering layer (103) and waveguiding layer (102) in such a way that, in the region of the waveguides (2, a1, a2, ... an, 40), the waveguiding layer (102) and the covering layer (103) remain.

14. Method of manufacturing an arrangement according to Claim 5 or Claim 5 and one of Claims 9 to 11, characterized in that a packet of layers, comprising at least an optically waveguiding layer (102), an absorption layer (104) covering the waveguiding layer (102) and a contact layer (105) covering the absorption layer, is produced on a substrate, in that the contact layer (105) and the absorption layer (104) are partially removed down as far as the waveguiding layer (102) in such a way that the absorption layer (104) and the contact layer (105) remain in local regions for photodiodes (d1, d2, ... dn), in that, outside the local regions, the waveguiding layer (102) is covered with a covering layer (103), in that, in the local regions provided for photodiodes (d1, d2, ... dn), with which contact is made by a contact layer (105) provided with a doping that is opposite to the doping present under the waveguiding layer (102), and in that, outside the local regions, the layer waveguide (2) having the diffraction grating (3) and strip-like waveguides (a1, a2, ... an, 40) is produced by partial removal of the covering layer (103) and waveguiding layer (102) in such a way that, in the region of the waveguides (2, a1, a2, ... an, 40), the waveguiding layer (102) and the covering layer (103) remain.

15. Method according to Claim 12, 13 or 14 for manufacturing an arrangement according to Claim 9 or 10, characterized in that, for the partial removal of the covering layer (103) and the waveguiding layer (102), the covering layer (103) is covered with a masking layer (107) which covers the layer waveguide (2) having the diffraction grating (3) and the strip-like waveguides (a1, a2, ... an, 40) in a defining way, in that a masking layer (7) that defines an input coupling waveguide (40) is covered with a second masking layer, which at the same time covers lateral regions of the covering layer (103), in that the covering layer (103) and the waveguiding layer (102) are partially removed in such a way that the covering layer (103) and waveguiding layer (102) remain under the masking layer (107) and second masking layer, in that the second masking layer is removed and in that, in the lateral region covered at the same time by the second masking layer and now exposed, the covering layer (103) is now removed down to the waveguiding layer (102) in such a way that the covering layer (103) remains under the masking layer (107).

## Revendications

1. Dispositif optique intégré pour démultiplexage de plusieurs longueurs d'onde optique différentes (λ₁, λ₂, ..., λₙ) comportant un guide d'ondes plan (2) intégré sur un substrat (1) et limité par un étage (21), qui présente un réseau de diffraction optique (3) réalisé sur l'étage (21) perpendiculairement au guide d'ondes plan (2),
- dans lequel les longueurs d'onde (λ₁, λ₂, ..., λₙ) peuvent être injectées dans la couche de guidage des ondes (2) en au moins un point d'injection (10) de l'étage (21) assigné conjointement à ces longueurs d'onde (λ₁,λ₂, ..., λₙ)
- dans lequel ces longueurs d'onde injectées (λ₁, λ₂, ..., λₙ) sont acheminées au réseau de diffraction (3) dans la couche de guidage des ondes (2),
- dans lequel le réseau de diffraction (3) sépare spatialement les longueurs d'onde (λ₁, λ₂, ..., λₙ) qui lui sont amenées en les diffractant dans différentes directions (r1, r2, ..., rn),
- dans lequel chaque longueur d'onde (λ₁, λ₂, ..., λₙ) séparée par le réseau de diffraction (3) est acheminée dans le guide d'ondes plan (2) vers un parmi plusieurs points de prélèvement (p1, p2,..., pn), spatialement séparés les uns des autres, de l'étage (21), et
- dans lequel à chaque point de prélèvement (p1, p2, ..., pn) la longueur d'onde (λ₁, λ₂, ..., λₙ) qui y est amenée peut être prélevée dans le guide d'ondes plan (2),
- dans lequel une longueur d'onde (λ₁, λ₂, ..., λₙ) est amenée au - au moins un - point d'injection (10) par un guide d'ondes d'injection (40) sous forme d'un guide d'ondes optiques en forme de bande intégré sur le substrat (1) et
- dans lequel un guide d'ondes de prélèvement (a1, a2, ..., an) conformé comme un guide d'ondes optiques en forme de bande intégré sur un substrat (1) est couplé optiquement à un point de prélèvement (p1, p2, ..., pn), lequel continue d'acheminer la longueur d'onde (λ₁, λ₂, ..., λₙ) prélevée à ce point de prélèvement (p1, p2, ..., pn),
caractérisé en ce que le guide d'ondes de prélèvement (a1, a2, ..., an) mène à un détecteur optique (d1, d2, ..., dn) intégré sur le substrat (1) et en ce qu'au moins un amplificateur optique (4) est intégré sur le substrat (1), lequel amplifie une ou plusieurs longueurs d'onde (λ₁, λ₂, ..., λₙ) à amener aux détecteurs optiques (d1, d2, ..., dn).

2. Dispositif selon la revendication 1, caractérisé en ce que le réseau de diffraction (3) est conformé comme un réseau optique de focalisation qui focalise les longueurs d'onde diffractées (λ₁, λ₂, ..., λₙ) sur les points de prélèvement (p1, p2, ..., pn).

3. Dispositif selon l'une des revendications précédentes, caractérisé en ce qu'un amplificateur optique (4) est formé dans un guide d'ondes d'injection (40) et/ou dans un guide d'ondes de prélèvement (a1, a2, ..., an).

4. Dispositif selon rune des revendications précédentes, caractérisé en ce que des guides d'ondes de prélèvement (a1, a2, ..., an) menant des points de prélèvement (p1, p2,..., pn) vers différents détecteurs optiques divergent dans l'espace.

5. Dispositif selon l'une des revendications précédentes, caractérisé en ce qu'un détecteur optique (d1, d2, ..., dn) est conformé comme une photodiode qui est couplée optiquement par un couplage à modes de fuite au guide d'ondes de prélèvement menant à cette diode (a1, a2,..., an).

6. Dispositif selon l'une des revendications précédentes, caractérisé par au moins un émetteur optique (8) intégré sur le substrat (1) et destiné à générer une longueur d'onde optique unique (λ₀) qui peut être injectée dans le guide d'ondes plan (2) en un autre point d'injection (100) de l'étage (21) qui diffère du
- au moins un - point d'injection (10), la longueur d'onde unique injectée (λ₀) étant acheminée dans le guide d'ondes plan (2) vers le réseau de diffraction (3), le réseau de diffraction (3) diffractant la longueur d'onde unique (λ₀) en direction (re) vers le point d'injection (10) et la longueur d'onde unique diffractée (λ₀) étant acheminée dans le guide d'ondes plan (2) vers le point d'injection (10) et pouvant être prélevée en ce point d'injection (10) du guide d'ondes plan (2).

7. Dispositif selon la revendication 6, caractérisé en ce que l'émetteur optique (8) est conformé comme un ou plusieurs lasers à semiconducteurs.

8. Dispositif selon la revendication 6 ou 7, caractérisé en ce que le réseau de diffraction (3) est conformé comme un réseau optique de focalisation qui focalise la longueur d'onde unique diffractée (λ₀) sur le point d'injection (10).

9. Dispositif selon rune des revendications précédentes, caractérisé en ce qu'un guide d'ondes de sortie (a1, a2, ..., an) est conformé comme un guide d'ondes en forme de bande.

10. Dispositif selon l'une des revendications précédentes, caractérisé en ce qu'un guide d'ondes d'injection (40) est conformé comme un guide d'ondes à nervures.

11. Dispositif selon rune des revendications précédentes, caractérisé en ce qu'un détecteur optique (d1, d2, ..., dn) est formé sur une zone (119) du substrat (1) élevée en forme mésa.

12. Procédé de fabrication d'un dispositif selon la revendication 5 ou selon la revendication 5 et l'une des revendications 9 à 11, caractérisé en ce que, sur un substrat (1), on crée un paquet de couches constitué d'au moins une couche de guidage des ondes optiques (102), d'une couche de revêtement (103) recouvrant la couche de guidage des ondes optiques, d'une couche d'absorption (104) recouvrant la couche de revêtement (103) et d'une couche de contact (105) recouvrant la couche d'absorption (104), dans lequel la couche de contact (105) est dotée, au moins dans des zones locales prévues pour des photodiodes (d1, d2, ..., dn) d'un dopage (109) opposé au dopage existant sous la couche de guidage des ondes (102), en ce que la couche de contact (105) est pourvue de contacts (108) dans les zones locales et en ce que le paquet de couches est réduit en dehors des zones locales par enlèvement de la couche de contact (105) et de la couche d'absorption (104) jusqu'à la couche de revêtement (103) de sorte que, dans les zones locales, subsistent les zones (119) élevées et sortant en forme mésa de la couche de revêtement (103) et qui présentent la couche de contact (105) et la couche d'absorption (104) dopées et dotées de contacts dont chaque zone définit une photodiode (d1, d2, ..., dn) couplée selon le mode de fuite à la couche de guidage des ondes (102) et en ce que, dans la zone du paquet de couches réduit, à l'extérieur des zones (119) élevées en forme mésa, on crée le guide d'ondes plan (2) avec l'étage (21) et le réseau de diffraction (3) conformé sur l'étage ainsi que des guides d'ondes en forme de bande (a1, a2,..., an, 40) par enlèvement de zones de la couche de revêtement (103) et de la couche de guidage des ondes (102) de manière à laisser subsister, dans la zone du guide d'ondes plan (2) avec l'étage (21) et les guides d'ondes en forme de bande (a1, a2, ..., an, 40), la couche de guidage des ondes (102) et la couche de revêtement (103).

13. Procédé de fabrication d'un dispositif selon la revendication 5 ou selon la revendication 5 et l'une des revendications 9 à 11, caractérisé en ce que, sur un substrat (1), on crée un paquet de couches constitué d'une couche de guidage des ondes optiques (102) et d'une couche de revêtement (103) recouvrant la couche de guidage des ondes (102), en ce que la couche de revêtement (103) est enlevée dans des zones locales prévues pour des photodiodes (d1, d2, ..., dn) jusqu'à la couche de guidage des ondes (103) de sorte que la couche de revêtement (103) située en dehors des zones locales subsiste, en ce que, dans les zones locales, on crée une couche d'absorption (104) sur la couche de guidage des ondes (102) dégagée et en ce que, sur la couche d'absorption (104), on crée une couche de contact (105) avec un dopage (109) opposé au dopage existant sous la couche de guidage des ondes (102) et en ce que, dans les zones locales prévues pour des photodiodes (d1, d2, ..., dn), on réalise des contacts avec la couche de contact (105) dopée et en ce que, en dehors des zones locales, on crée un guide d'ondes plan (2) avec le réseau de diffraction (3) et des guides d'ondes en forme de bande (a1, a2, ..., an, 40) par enlèvement de zones de la couche de revêtement (103) et de la couche de guidage des ondes (102) de manière à laisser subsister dans la zone des guides d'ondes (2, a1, a2, ..., an,40), la couche de guidage des ondes (102) et la couche de revêtement (103).

14. Procédé de fabrication d'un dispositif selon la revendication 5 ou la revendication 5 et l'une des revendications 9 à 11, caractérisé en ce que sur un substrat on crée un paquet de couches composé d'au moins une couche de guidage des ondes optiques (102), d'une couche d'absorption (104) recouvrant la couche de guidage des ondes (102) et d'une couche de contact (105) recouvrant la couche d'absorption, en ce que des zones de la couche de contact (105) et de la couche d'absorption (104) sont enlevées jusqu'à la couche de guidage des ondes (102) de sorte que la couche d'absorption (104) et la couche de contact (105) subsistent dans des zones locales prévues pour des photodiodes (d1, d2, ..., dn), en ce que, en dehors des zones locales, la couche de guidage des ondes (102) est recouverte d'une couche de revêtement (103), en ce que, dans les zones locales prévues pour des photodiodes (d1, d2, ..., dn), on réalise des contacts avec la couche de contact (105) pourvue d'un dopage (109) opposé au dopage existant sous la couche de guidage des ondes (102) et en ce que, en dehors des zones locales, on crée le guide d'ondes plan (2) avec le réseau de diffraction (3) et des guides d'ondes en forme de bande (a1, a2, ..., an) par enlèvement de zones de la couche de revêtement (103) et de la couche de guidage des ondes (102) de manière à laisser subsister dans la zone des guides d'ondes (2, a1, a2, ..., an, 40) la couche de guidage des ondes (102) et la couche de revêtement (103).

15. Procédé selon la revendication 12, 13 ou 14 destiné à la fabrication d'un dispositif selon la revendication 9 ou 10, caractérisé en ce que, pour enlever des zones de la couche de revêtement (103) et de la couche de guidage des ondes (102), la couche de revêtement (103) est recouverte d'une couche de masquage (107) qui recouvre de façon définie le guide d'ondes plan (102) avec le réseau de diffraction (3) et les guides d'ondes en forme de bande (a1, a2, ...., an, 40), en ce qu'une couche de masquage (107) définissant un guide d'ondes d'injection (40) est recouverte par une deuxième couche de masquage qui recouvre aussi des zones latérales de la couche de revêtement (103), en ce que des zones de la couche de revêtement (103) et de la couche de guidage des ondes (103) sont enlevées de manière à ce que la couche de revêtement (103) et la couche de guidage des ondes (102) subsistent sous la couche de masquage (107) et la deuxième couche de masquage, en ce que la deuxième couche de masquage est enlevée et en ce que la couche de revêtement (103) est enlevée jusqu'à la couche de guidage des ondes (102) dans la zone latérale qui était recouverte par la deuxième couche de masquage et qui est à présent dégagée de manière à ce que la couche de revêtement (103) subsiste sous la couche de masquage (107).
